# DEMANDE DE BREVET EUROPEEN

(11) **EP 2 757 637 A1**
(43) Date de publication de la demande: **23.07.2014**
(21) Numéro de dépôt: 13195507.2
(22) Date de dépôt: 13.10.2011
(51) Int. Cl.: H01R 12/55, F01L 9/04, H01R 12/57, H01R 12/71, H01R 13/22, H05K 1/14

(54) **Circuit électronique comportant des connexions électriques résistantes à un environnement sévère**

(30) Priorité: 22.12.2010 FR 1061094
(62) Demande divisionnaire de: 11832110.8
(71) Demandeur: Valeo Systèmes De Contrôle Moteur, 95800 Cergy St Christophe (FR)
(72) Inventeur: Falchi, Danilo, 95000 CERGY (FR); Dupuis, Dominique, 95820 BRUYERES SUR OISE (FR); Bonvallat, Guillaume, 60110 MERU (FR); Herault, Fabrice, 78410 FLINS SUR SEINE (FR)

(57) **Abrégé**

L'invention concerne un connecteur électrique (25a) pour un circuit électronique, ledit connecteur (25a) étant en forme de lame et comprenant :
- une première partie formant un pied (32a) ayant une première sous-partie (33a) s'étendant sensiblement suivant un plan et destinée à être assemblée par brasure sur ledit circuit électronique,
- une deuxième partie (30a) s'étendant suivant une direction sensiblement transversale à ladite sous-partie de brasure (33a) de la première partie (32a) et comprenant une surface de contact destinée à être mise en contact avec un connecteur électrique.

## Description

L'invention concerne la réalisation de connexions électriques entre deux circuits électriques ou deux portions de circuit électrique. Elle s'applique en particulier à des actionneurs électromagnétiques.

### ARRIERE-PLAN DE L'INVENTION

Les systèmes de motorisation les plus répandus comprennent généralement un moteur thermique à combustion interne comportant un bloc moteur délimitant des chambres de combustion ayant une extrémité fermée par une culasse et une extrémité opposée fermée par un piston reçu à coulissement dans le bloc moteur. Les pistons sont reliés par une bielle à un vilebrequin agencé pour transformer le mouvement de coulissement alternatif des pistons en un mouvement de rotation continu communiqué aux roues motrices du véhicule via l'embrayage et la boîte de vitesses. La culasse comprend des conduits de raccordement des chambres de combustion à un circuit d'alimentation en air et à un circuit d'échappement des gaz brûlés. Dans les moteurs thermiques à quatre temps, ces moyens de raccordement comprennent des soupapes mobiles entre une position d'obturation des conduits et une position d'ouverture des conduits.

Dans le domaine automobile, la recherche de la réduction de la consommation et des émissions de dioxyde de carbone conduisent les constructeurs à intégrer des composants électroniques au coeur du moteur afin d'en contrôler finement chaque paramètre. Le compartiment moteur d'un véhicule est un environnement sévère où règne une température élevée, des vibrations et une atmosphère saturée de brouillard d'huile. Les composants électroniques et les circuits électroniques en particulier doivent être protégés de la température et de l'huile en particulier.

Afin d'optimiser le rendement du moteur, les organes purement mécaniques, tels que l'arbre à cames d'actionnement des soupapes, sont fréquemment remplacés par des actionneurs électromagnétiques contrôlés par un circuit électronique. Ces circuits électroniques sont implantés au plus près des actionneurs pour limiter les câbles entre les organes de commande et les actionneurs.

Les actionneurs sont pilotés par un circuit électronique de commande intégrant une électronique de calcul, une électronique de puissance, des capteurs, des interfaces... Ainsi, les circuits, qui sont réalisés sur un support rigide plan, peuvent être volumineux et occuper une place importante compte tenu des fonctions intégrées.

Pour limiter le volume occupé par les circuits électroniques, le support du circuit pourrait être fixé sur une face du boîtier de l'actionneur. Toutefois, la dimension du circuit serait alors limitée à la taille du boîtier de l'actionneur.

Pour limiter le volume occupé par l'actionneur, il est envisagé de scinder le circuit de commande en plusieurs parties réparties sur plusieurs faces du boîtier de l'actionneur. Les parties seraient ensuite reliées entre elles électriquement.

Les moyens de raccordement classiques mettent en oeuvre une connexion électrique comportant une partie mâle venant s'insérer dans un receveur femelle, telle une connexion par broches. Dans les connexions à broches multiples, une partie du circuit comporte une série de fiches femelles organisées en peigne et l'autre partie du circuit comporte une grille mâle recevant les fiches femelles. Toutefois, dans l'environnement sévère du moteur, ce type de connexion n'offre pas la résistance suffisante pour garantir le fonctionnement du circuit dans le temps, car le contact entre les parties mâles et femelles de la connexion se fait par pincement. Par ailleurs, une telle connexion nécessite une grande précision dans la réalisation, car les fiches sont en général petites et ne supportent pas les déformations.

L'invention propose donc un nouveau type de connexion adapté à l'environnement du moteur.

### OBJET DE L'INVENTION

L'invention concerne un premier connecteur électrique d'un circuit électronique, ledit connecteur étant en forme de lame et comprenant :
- une première partie formant un pied ayant une première sous-partie s'étendant sensiblement suivant un plan et destinée à être assemblée par brasure sur ledit circuit électronique,
- une deuxième partie s'étendant suivant une direction sensiblement transversale à ladite sous-partie de brasure de la première partie et comprenant une surface de contact destinée à être mise en contact avec un connecteur électrique.

Selon un mode de réalisation du connecteur, la première partie comporte un élément flexible entre la sous-partie de brasure et ladite deuxième partie.

Selon un mode de réalisation du connecteur, l'élément flexible comporte au moins un pliage.

Selon un mode de réalisation du connecteur, l'élément flexible a sensiblement une forme de S.

Selon un mode de réalisation du connecteur, la sous-partie de brasure comprend au moins deux pattes s'étendant suivant sensiblement la même direction et séparées par une patte médiane s'étendant suivant la même direction mais dans un sens opposé aux deux pattes.

Selon un mode de réalisation, le connecteur comprend un matériau thermiquement conducteur.

L'invention concerne en outre un second connecteur électrique d'un circuit électronique, ledit connecteur étant en forme de lame et ayant une partie comprenant une surface destinée à venir en contact avec la surface de contact de la deuxième partie du premier connecteur électrique.

L'invention concerne aussi un ensemble de connexion électrique d'un circuit électronique comprenant le premier connecteur selon l'invention et le second connecteur selon l'invention.

L'invention concerne également un circuit électronique comprenant un support et au moins le premier connecteur selon l'invention, ladite première sous-partie de la première partie du connecteur étant brasée sur le support.

L'invention concerne un circuit électronique comportant au moins deux parties distinctes les parties du circuit étant reliées électriquement par des connexions comprenant au moins deux connecteurs reliés chacun à une partie du circuit, chaque connecteur comportant une surface de contact sensiblement plane et des moyens pour lier rigidement les surfaces de contact entre elles.

Ainsi, les connexions permettant la liaison électrique entre les parties du circuit sont rigides et peuvent supporter les températures élevées et les vibrations. La connexion ne comporte pas de partie mâle ou femelle ce qui permet de réaliser une liaison mécanique forte, par exemple par soudage.

Avantageusement, les connecteurs peuvent comporter un pied flexible permettant d'ajuster les positions respectives des connecteurs avant assemblage et qui permet d'apporter de la souplesse dans la connexion afin de mieux résister aux vibrations et à la dilatation des composants.

Selon un mode de réalisation du circuit électronique, le connecteur comporte une lame comprenant au moins une surface de contact électrique et un pied prolongeant la lame et reliant la lame à une partie du circuit.

Selon un mode de réalisation du circuit électronique, les connecteurs sont agencés de sorte que la lame d'un connecteur d'une première partie est disposée parallèlement à au moins une lame d'une deuxième partie de sorte que les surfaces de contact de chaque lame soient en contact.

Selon un mode de réalisation du circuit électronique, les connecteurs sont connectés par soudage.

Selon un mode de réalisation du circuit électronique, les connecteurs sont connectés par des moyens mécaniques.

Selon un mode de réalisation du circuit électronique, les connecteurs comportent un pied flexible.

L'invention concerne aussi un actionneur électromagnétique comportant un circuit électronique selon l'invention.

L'invention concerne également un actionneur électromagnétique comportant un boîtier ayant plusieurs faces et un circuit électronique de commande scindé en au moins deux parties qui sont réparties sur au moins deux faces adjacentes du boîtier. Conformément à l'invention, chaque partie du circuit comporte au moins un connecteur métallique agencé pour être connecté électriquement et mécaniquement avec un connecteur métallique d'une autre partie du circuit afin de former une connexion électrique.

Le circuit électronique peut intégrer entre autre une électronique de calcul, une électronique de puissance, des capteurs ou des interfaces. Le circuit électronique commande par exemple le fonctionnement et/ou la puissance du signal délivré à l'actionneur. En particulier, le circuit est aussi appelé circuit électronique de puissance lorsqu'il intègre une électronique de puissance.

Selon un mode de réalisation de l'actionneur, les connexions sont disposées pour former des dents d'au moins deux peignes, les dents des peignes étant décalées.

Selon un mode de réalisation de l'actionneur, chaque connecteur comporte une surface de contact électrique sensiblement plane et des moyens pour lier rigidement les surfaces de contact entre elles.

Selon un mode de réalisation de l'actionneur, les connecteurs comportent une lame comprenant au moins la surface de contact électrique et un pied prolongeant la lame et reliant la lame à une partie du circuit.

Selon un mode de réalisation de l'actionneur, les connecteurs sont agencés de sorte que la lame d'un connecteur d'une première partie est disposée parallèlement à au moins une lame d'une deuxième partie de sorte que les surfaces de contact de chaque lame soient en contact.

Selon un mode de réalisation de l'actionneur, une première partie de circuit est réalisée sur une première portion de support fixée sur une face supérieure du boîtier, une deuxième partie de circuit est réalisée sur une deuxième portion de support fixée sur une face avant du boîtier, et les connecteurs de la première partie de circuit comportent une lame orientée perpendiculairement à la face supérieure du boîtier alors que les lames des connecteurs de la seconde partie de circuit sont orientées parallèlement à la face avant du boîtier.

Selon un mode de réalisation de l'actionneur, les connecteurs sont connectés par soudage.

Selon un mode de réalisation de l'actionneur, les connecteurs sont connectés par des moyens mécaniques.

Selon un mode de réalisation de l'actionneur, les connecteurs comportent un pied flexible.

### BREVE DESCRIPTION DES DESSINS

Il sera fait référence aux dessins annexés, parmi lesquels :
- la figure 1 est une vue d'un système de motorisation selon l'invention ;
- la figure 2 illustre un actionneur, vu en figure 1, sans son capotage selon l'invention ;
- la figure 3 est une vue de détail d'un premier mode de réalisation des connecteurs du circuit électronique d'un actionneur illustré en figure 2 ;

- la figure 4 est une vue de détail d'un deuxième mode de réalisation des connecteurs du circuit électronique d'un actionneur illustré en figure 2 ;
- la figure 4a est une vue de détail d'une connexion vue en figure 4 ;
- la figure 5 présente un exemple de connecteur électrique selon l'invention ;
- la figure 6 présente un autre exemple de connecteur électrique selon l'invention ;
- la figure 7 est encore un autre exemple de connecteur électrique selon l'invention ;
- La figure 8 présente un exemple d'une carte électronique selon l'invention.

### DESCRIPTION DETAILLEE DE L'INVENTION

L'idée à la base de l'invention est de répartir le circuit électronique sur les faces du boîtier de l'actionneur afin d'obtenir un boîtier compact et intégrant un circuit électronique complet.

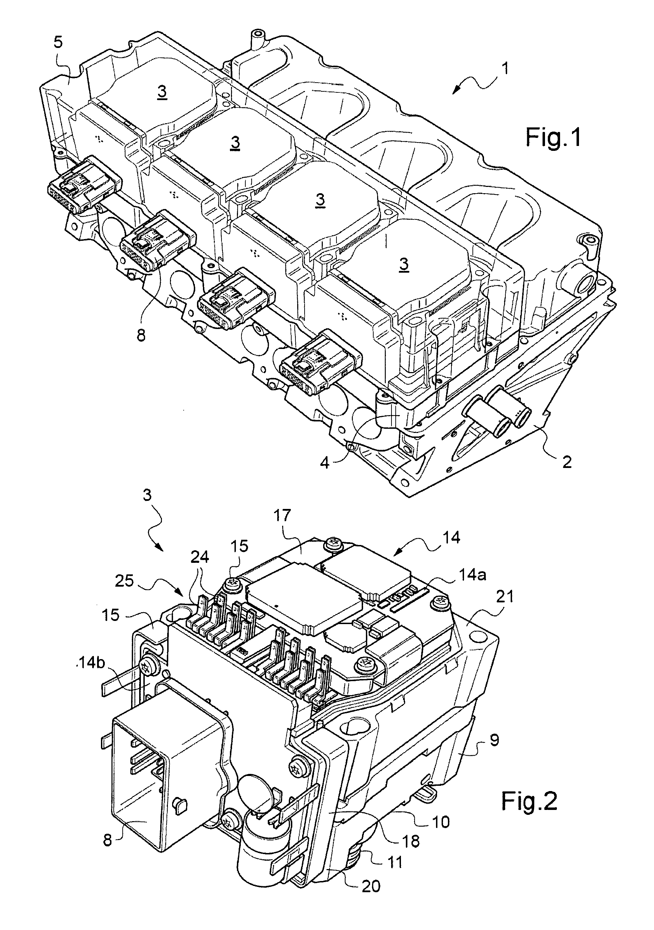

La figure 1 illustre un système de motorisation comprenant un moteur 1 thermique à combustion interne à quatre temps. Le moteur 1 est formé d'un bloc moteur (non représenté) et d'une culasse 2 montée sur le bloc moteur et recouverte d'un capot de culasse 5 délimitant avec la culasse 2 un logement pour un groupe d'actionneurs 3 de soupapes. Les actionneurs 3 sont fixés à la culasse 2 et reposent sur celle-ci chacun par une semelle 4. Le capot de culasse 5 est ici représenté transparent pour laisser entrevoir les actionneurs 3. La structure générale et le fonctionnement d'un tel moteur thermique sont connus en eux-mêmes et ne seront pas plus détaillés ici.

Les actionneurs 3 de soupapes permettent l'actionnement des soupapes d'admission et d'échappement en remplacement d'un arbre à cames. Il est ainsi possible de commander chaque soupape individuellement et de réaliser des cycles de combustion complexes et optimisés. Les actionneurs sont réalisés comme des organes autonomes. Ils comportent des organes de déplacement des soupapes, généralement une tige coulissante d'actionnement ayant une extrémité coopérant avec la soupape et une extrémité solidaire d'une palette reçue dans des bobines électromagnétiques aptes à exercer un effort d'attraction sur la palette selon des directions opposées. Les bobines sont reliées à un circuit électronique intégré commandant et alimentant en puissance les organes de déplacement des soupapes.

La figure 2 illustre plus particulièrement un des actionneurs vus sur la figure 1.

Dans cet exemple de réalisation, l'actionneur comporte un boîtier 9, métallique, renfermant les organes de déplacement des soupapes. On distingue en outre sur une face inférieure 10 du boîtier 9 une tige d'actionnement soupape 11 et son ressort de rappel qui dépassent du boîtier 9 et qui sont destinés à être insérés dans la culasse 2. L'actionneur 3 comporte également une prise 8 de connexion disposée sur la face avant et qui permet de relier le circuit électronique 14 à une source de puissance et à une unité de gestion du moteur ou ECU (de l'anglais « Engine Control Unit »).

Plus précisément, le circuit électronique portant la référence 14 comprend un support 15, scindé en une première portion de support 17 et une seconde portion de support 18, et des composants électroniques répartis sur chaque portion de support 17, 18. Les portions de support 17, 18 sont chacune fixées respectivement sur une face du boîtier 9, ici sur la face supérieure 21 et sur la face avant 20. Le circuit électronique 14 comprend ainsi deux parties 14a et 14b qui sont reliées électriquement entre elles via des connexions électriques 24.

La première partie de circuit 14a est réalisée sur une première portion de support 17 qui est fixée sur la face supérieure 21 du boîtier. Une deuxième partie de circuit 14b est réalisée sur une deuxième portion de support 18 fixée sur la face avant 20.

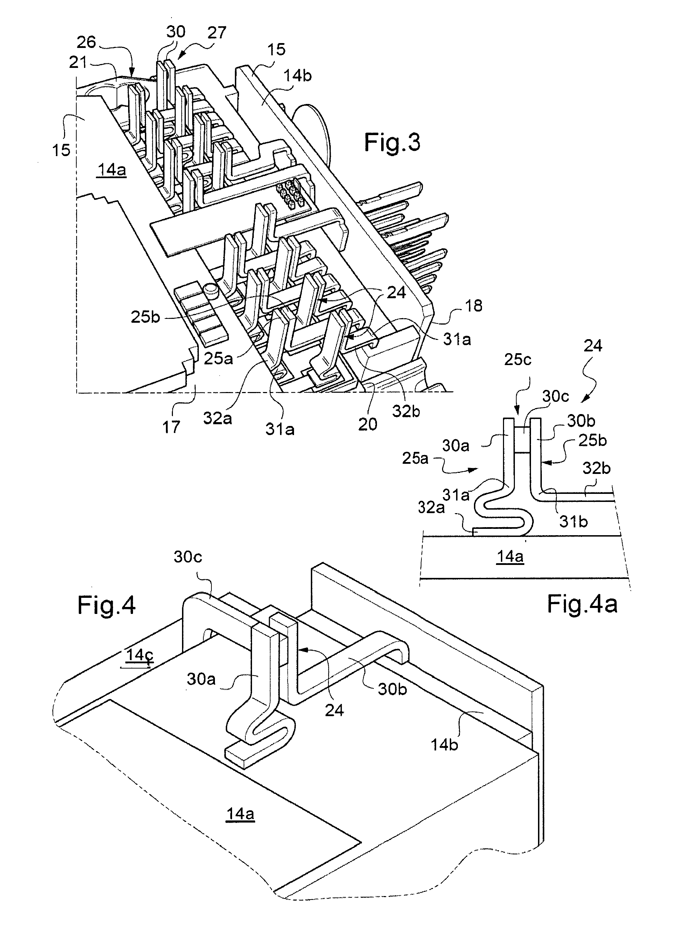

Les parties de circuit 14a et 14b sont électriquement reliées par des connexions 24 agencées en deux peignes 26 et 27 parallèles comme illustrés à la figure 3.

Les connexions 24 sont formées par l'assemblage mécanique rigide d'un connecteur 25a et d'un connecteur 25b qui sont électriquement reliés respectivement aux parties de circuit 14a et 14b.

Chaque connecteur 25 comprend une lame 30 rigide comportant une surface de contact destinée à être mise en contact avec la surface de contact de la lame 30 d'un autre connecteur 25. Les lames 30 sont portées par un pied 32 qui relie électriquement et mécaniquement la lame 30 à la partie de circuit électronique dont dépend le connecteur.

Le boîtier 9 de l'actionneur étant un parallélépipède, les connecteurs 25a de la partie de circuit 14a comportent une lame 30a orientée perpendiculairement à la face supérieure 21 du boîtier alors que les lames 30b des connecteurs 25b de la partie de circuit 14b sont orientées parallèlement à la face avant 20 du boîtier 9.

Les connecteurs sont montés sur les portions de support 17, 18 pour que chaque connecteur 25a soit placé face à un connecteur 25b lorsque les parties de circuit 14a, 14b sont fixées sur le boîtier 9. Ainsi, chaque lame 30 de chaque connecteur 25 est placée parallèlement à la lame 30 du connecteur 25b correspondant, les surfaces de contact se faisant face.

Les lames 30 des connecteurs 25a et 25b sont ensuite assemblées par soudage pour former la connexion 24.

L'agencement des connexions 24 en plusieurs peignes parallèles, dont les dents sont décalées, permet d'espacer davantage les connexions 24, ce qui facilite l'assemblage des connecteurs 25. Il est possible d'aligner les connexions 24 sur un seul peigne, mais la proximité des connexions 24 conduirait à une opération de soudage plus délicate.

Les connexions 24 ainsi réalisées résistent parfaitement à la température et aux vibrations, car elles réalisent également des liaisons mécaniques.

Avantageusement, les connexions 24 peuvent comporter un élément flexible afin de faciliter la mise en contact des lames 30 entre elles et d'améliorer la résistance de la connexion 24 à la dilatation et aux vibrations.

Ainsi, comme illustré en figure 3, les pieds 32a et 32b respectifs des connecteurs 24a et 24b comportent respectivement des ressorts 31a et 31b.

Le connecteur 24a comporte un pied 32a comprenant un ressort 31a formé d'un pliage en « S » de l'extrémité inférieure de la lame 30. Le ressort en « S » permet de relier la lame 30 à la partie de circuit 14a sur une faible longueur tout en ajoutant une flexibilité à la lame 30, car la forme en « S » du ressort est à la fois compacte et flexible.

De façon similaire, le connecteur 24b comporte un pied 32b comprenant un ressort 31b formé par une lamelle ressort 35 perpendiculaire à la lame 30 et prolongeant cette dernière. La lamelle permet également de réaliser la liaison électrique entre la lame 30 et la partie de circuit 14b.

Bien entendu, l'invention n'est pas limitée au mode de réalisation décrit précédemment.

Ainsi, le choix du type de ressort dépend essentiellement de l'orientation des connecteurs et de la distance séparant les lames 30 des parties de circuit. L'orientation des connecteurs 25b permet avantageusement d'utiliser des lamelles ressorts 31b qui sont faciles à réaliser et permettent de relier les connecteurs 25b à la partie de circuit 14b.

De façon similaire, les ressorts 31a en « S » sont adaptés au connecteur 25a, car ils sont compacts et permettent d'orienter ces derniers perpendiculairement à la partie de circuit 14a.

L'assemblage des connecteurs 25 est réalisé préférentiellement par soudage. Toutefois, tout procédé permettant d'assembler rigidement les lames 30 est envisageable, pourvu que la liaison électrique soit établie. Ainsi, il est possible d'assembler les lames par vis et écrou, ou par un autre élément mécanique de type agrafe.

Il est important de noter que les termes « première partie et deuxième partie de circuit » ont été choisis sans relation avec une priorité d'une partie de circuit sur l'autre. En effet, la position des connecteurs, leurs orientations respectives par rapport aux faces du boîtier, leur nombre et leur disposition respective ne sont données qu'à titre d'exemple.

IL est également possible de scinder le circuit électronique en plus de deux parties.

Si le circuit comporte trois parties distinctes, fixées sur des faces adjacentes, il est possible d'utiliser les mêmes connecteurs pour relier électriquement les parties entre elles. Ainsi, les lames 30 des connecteurs peuvent être orientées perpendiculairement entre elles, pourvu que les surfaces de contact des lames 30 soient parallèles afin de pouvoir réaliser l'assemblage. La figure 4 illustre un exemple de connexion entre trois parties de circuit 14a, 14b et 14c grâce à des connecteurs 25a 25b et 25c. Les parties de circuits sont fixées sur des faces du boîtier 9 perpendiculaires et adjacentes et la connexion 25 est réalisée au droit de la face du boîtier 9 comportant la partie de circuit 14c.

La figure 4a est un gros plan de la connexion 25 de profil qui fait apparaître les contacts entre les trois connecteurs. Les lames 30b et 30a sont dirigées parallèlement tandis que la lame 30c est perpendiculaire aux deux autres en étant prise entre les lames 30a et 30b.

L'assemblage des lames se fait comme décrit précédemment et de préférence par soudage.

Ainsi, il est possible de scinder le circuit électrique en autant de parties que le boîtier possède de face. Les liaisons électriques entre les parties du circuit sont réalisables de préférence comme indiqué précédemment, mais d'autres types de connexions sont possibles comme des broches ou des fils électriques souples soudés entre deux points.

Pour simplifier la fabrication comme l'installation du circuit électronique, il est également possible de réaliser le support 15 du circuit d'un seul tenant. Selon l'exemple de réalisation illustré en figure 2, le support comporte une première portion 17 et une deuxième portion 18, indépendantes, fixées indépendamment l'une de l'autre sur le boîtier 9. Mais il est possible de réaliser un support rigide d'un seul tenant, en forme de « L » ou de cornière, qui serait ensuite fixé sur le boîtier 9. Les liaisons électriques entre les parties de circuit pourraient ainsi être réalisées directement sur le support selon un procédé connu.

Ainsi, le circuit est scindé en deux parties réparties sur deux faces du boîtier, mais un seul support 15 est nécessaire.

Avantageusement, chaque portion de support 17, 18 incorpore des moyens de connexion 25a, 25b reliés entre eux et aux parties du circuit 14a, 14b pour assumer une liaison électrique des parties de circuit 14a, 14b l'une à l'autre. Ainsi, les connecteurs 25a, 25b, sont portés par leurs supports respectifs.

Les connecteurs 25a, 25b vont être plus précisément décrits en faisant référence aux figures 4 à 8.

Un premier connecteur 25a a une forme de lame et constitue une pièce de connexion électrique d'un circuit électronique 14a.

Le premier connecteur 25a comprend une première partie formant un pied 32a ayant une première sous-partie 33a s'étendant sensiblement suivant un plan. Cette première sous-partie 33a est destinée à être assemblée par brasure sur le circuit électronique.

Le premier connecteur 25a comprend en outre une deuxième partie 30a s'étendant suivant une direction sensiblement transversale, voire perpendiculaire, à la sous-partie de brasure 33a de la première partie 32a. La deuxième partie 30a comprend une surface de contact destinée à être mise en contact avec un connecteur électrique.

Dans le connecteur 25a, le pied 32a éloigne la surface de contact de la sous-partie de brasure 33a suivant une direction transversale à la sous-partie de brasure. Ainsi, lorsque le connecteur 25a est monté sur le circuit électronique, une connexion électrique ultérieure du circuit électronique peut être obtenue sans nécessiter un accès à la surface du circuit. En effet, le premier connecteur 25a déporte la surface de contact au dessus du circuit électronique. Ainsi, on s'affranchit de contraintes environnementales du circuit électronique qui peuvent empêcher l'accès des outils de soudure à la surface du circuit électronique.

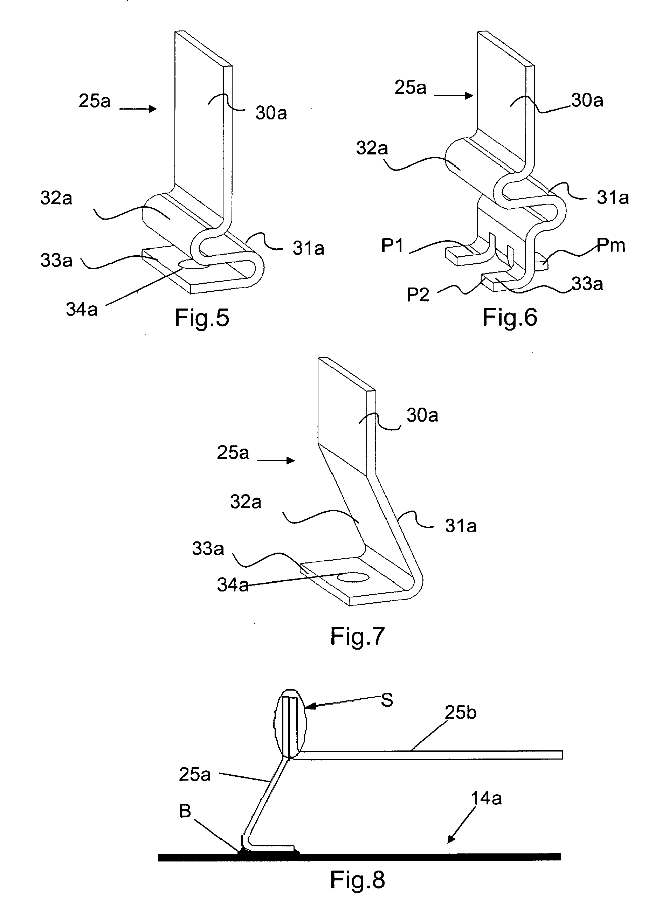

La sous-partie de brasure 33a assure un contact mécanique et électrique entre le premier connecteur 25a et le circuit électronique. Elle est configurée pour assurer une assise du premier connecteur 25a sur le circuit électronique. Par exemple, la sous-partie de brasure 33a est en forme d'un parallélépipède plat, comme illustré en figure 5. Dans un autre exemple illustré en figure 6, la sous-partie de brasure 33a comprend au moins deux pattes P1, P2 s'étendant suivant sensiblement la même direction et séparées par une patte médiane Pm s'étendant suivant la même direction mais dans un sens opposé aux deux pattes P1, P2.

La sous-partie de brasure peut comprendre un trou 34a permettant de positionner le premier connecteur 25a sur la surface du circuit électronique 14a. Par exemple, le trou 34a est destiné à recevoir un pion issu de la surface du circuit électronique 14a.

Grâce à la sous-partie de brasure 33a, le premier connecteur 25a peut être monté en surface sur le circuit électronique 14a, par exemple en même temps que d'autres composants CMS (pour Composants Montés en Surface). Une fois monté sur le circuit, le premier connecteur 25a s'étend à partir d'une seule face du circuit.

La première partie du premier connecteur 25a peut comporter un élément flexible 31a entre la sous-partie de brasure 33a et la deuxième partie 30a. L'élément flexible 31a permet d'absorber les jeux mécaniques lors de l'assemblage du premier connecteur 25a sur le circuit 14a ou lors de la mise en contact de la surface de contact, avec par exemple un second connecteur 25b. L'élément flexible 31a permet en outre de compenser les dilatations différentielles des connecteurs et du circuit électronique lors des variations de température.

Par exemple, l'élément flexible 31a comporte au moins un pliage. Les figures 5 à 7 présentent des exemples de premier connecteur 25a. En figures 5 et 6, l'élément flexible a sensiblement une forme de S. En figures 7, la flexibilité est obtenue par un seul pliage.

Par exemple, le premier connecteur électrique 25a comprend un matériau thermiquement conducteur. Ainsi, le premier connecteur 25a permet de dissiper la chaleur générée par la connexion électrique, par exemple par un second connecteur 25b. En particulier, le premier connecteur 25a permet un transfert de chaleur par l'intermédiaire du circuit électronique jusqu'à un refroidisseur sur lequel pourrait être positionné le circuit.

Lorsque le premier connecteur 25a est monté sur le circuit électronique 14a, un second connecteur électrique 25b peut alors être mis en contact électrique, en particulier lié rigidement, avec la surface de contact du premier connecteur 25a. On réalise ainsi la connexion électrique du circuit électronique 14a avec par exemple un autre circuit électronique ou une source d'énergie telle qu'une batterie.

La connexion électrique du circuit électronique 14a peut donc être réalisée à distance de la surface du circuit électronique. Le point de liaison électrique entre le second connecteur 25b et le circuit électronique est déporté à une distance suivant une direction perpendiculaire au circuit électronique 14a. La connexion électrique du circuit électronique 14a s'affranchit donc des difficultés d'accès à la surface du circuit.

Le second connecteur électrique 25b de circuit électronique peut être en forme de lame et avoir une partie 30b comprenant une surface destinée à venir en contact avec la surface de contact du premier connecteur 25a. En particulier, le contact entre le premier connecteur 25a et le second connecteur 25b peut être réalisé par soudure.

Dans le cadre de la présente demande, le circuit électronique est par exemple une carte électronique ayant un support et des composants électroniques montés sur une surface du support, encore appelée PCB (pour « Printed Circuit Board » en anglais). Par exemple, le premier connecteur 25a est monté sur la carte électronique avec d'autres composants électroniques. La fixation du premier connecteur 25a et des composants peut être réalisée par brasage lors d'un passage dans un four.

La figure 8 présente un exemple de carte électronique 14a qui comprend au moins le premier connecteur 25a. La surface de brasure 33a du premier connecteur 25a peut être assemblée au support de la carte 14a par une brasure B.

Le second connecteur 25b peut ultérieurement venir en contact électrique avec le premier conducteur 25a. De préférence, les surfaces de contact des conducteurs 25a, 25b s'étendent suivant un plan et sont placées en vis-à-vis l'une par rapport à l'autre. La connexion entre les surfaces de contact des connecteurs 25a, 25b est donc réalisée suivant un plan. Par exemple, la connexion entre les surfaces de contact est réalisée par une soudure S. Toutefois, tout procédé permettant d'assembler rigidement les surfaces de contact est envisageable, pourvu que la liaison électrique soit établie. Ainsi, il est possible d'assembler les lames par vis et écrou, ou par un autre élément mécanique de type agrafe.

## Revendications

1. Connecteur électrique (25a) pour un circuit électronique (14a), ledit connecteur (25a) étant en forme de lame et comprenant :
- une première partie formant un pied (32a) ayant une première sous-partie (33a) s'étendant sensiblement suivant un plan et destinée à être assemblée par brasure sur ledit circuit électronique (14a),
- une deuxième partie (30a) s'étendant suivant une direction sensiblement transversale à ladite sous-partie de brasure (33a) de la première partie (32a) et comprenant une surface de contact destinée à être mise en contact avec un connecteur électrique.

2. Connecteur selon la revendication 1, dans lequel la première partie (32a) comporte un élément flexible (31a) entre la sous-partie de brasure (33a) et ladite deuxième partie (30a).

3. Connecteur selon la revendication 2, dans lequel l'élément flexible (31a) comporte au moins un pliage.

4. Connecteur selon les revendications 2 ou 3, dans lequel l'élément flexible (31a) a sensiblement une forme de S.

5. Connecteur selon l'une des revendications précédentes, dans lequel la sous-partie de brasure (33a) comprend au moins deux pattes (P1, P2) s'étendant suivant sensiblement la même direction et séparées par une patte médiane (Pm) s'étendant suivant la même direction mais dans un sens opposé aux deux pattes (P1, P2).

6. Connecteur selon l'une des revendications précédentes, dans lequel le connecteur comprend un matériau thermiquement conducteur.

7. Connecteur électrique (25b) pour un circuit électronique, ledit connecteur (25b) étant en forme de lame et ayant une partie (30b) comprenant une surface destinée à venir en contact avec la surface de contact de la deuxième partie (30a) d'un connecteur électrique selon l'une des revendications précédentes.

8. Ensemble de connexion électrique pour un circuit électronique comprenant un premier connecteur (25a) selon l'une des revendications 1 à 6 et un second connecteur (25b) selon la revendication 7.

9. Circuit électronique (14a) comprenant un support et au moins un premier connecteur (25a) selon l'une des revendications 1 à 6, ladite première sous-partie (33a) de la première partie (32a) du connecteur (25a) étant brasée sur le support.

10. Actionneur électromagnétique comportant un boîtier (9) ayant plusieurs faces (20, 21) et un circuit électronique (14) scindé en au moins deux parties (14a, 14b) réparties sur au moins deux faces (20, 21) adjacentes du boîtier (9), chaque partie (14a) du circuit comportant au moins un connecteur métallique (25a) selon l'une des revendications 1 à 6 agencé pour être connecté électriquement et mécaniquement avec un connecteur métallique (25b) selon la revendication 7 d'une autre partie du circuit (14b) afin de former une connexion électrique (24).
